# EUROPEAN PATENT SPECIFICATION

(11) **EP 0 418 468 B1**
(45) Date of publication and mention of the grant of the patent: **25.01.1995**
(21) Application number: 90109000.1
(22) Date of filing: 12.05.1990
(51) Int. Cl.: H01L 21/314, C23C 16/34, C23C 16/40

(54) **Method for producing an ultra-thin dielectric for microelectronics applications**
Verfahren zur Herstellung eines ultradünnen Dielektrikums für mikroelektronische Verwendung
Procédé de fabrication d'un diélectrique ultra-mince pour applications en microélectronique

(30) Priority: 20.09.1989 US 412250
(43) Date of publication of application: 27.03.1991
(73) Proprietor: International Business Machines Corporation, Armonk, N.Y. 10504 (US)
(72) Inventor: Nguyen, Thao Ngoc, Yorktown Heights, New York 10598 (US); Stein, Kenneth Jay, Sandy Hook, Connecticut 16482 (US); Sun, Yuan-Chen, Yorktown Heights, New York 10598 (US); Weinberg, Zeev Avraham, White Plains, New York 10601 (US)
(74) Representative: Schäfer, Wolfgang, Dipl.-Ing.

(56) References cited:
- WO-A-87/06762
- US-A- 4 438 157
- Electrochemical Society extended abstracts vol. 86-2, no. 408, 1986, pages 618- 619; K.K. YOUNG et al.: "Preparation and Characterization of 100 AngströmOxide/Nitride/Oxide Stacked Films"
- Journal of the Electrochemical Society vol. 135, no. 3, March 1988, pages 776 -
- 777; B.Y. NGUYEN et al.: "Influences of processing chemistry of Silicon Nitridefilms on the charge trapping behavior of Oxide/CVD-Nitride/Oxide capacitors"
- Japanese Journal of Applied Physics Supplement 22-1 1982, Japan pages 581 -582; E. SUZUKI et al.: "A low voltage alterable Metal-Oxide-Nitride Oxide-Semiconductor memory with nano-meter thick gate insulators NM-MONOS "
- 1987 Digest of techn. papers of sympos. on VLSI Techno., KARUIZAWA, Japan 18May 1987, pages 25 - 26; L. DORI et al.: "Very thin Nitride/Oxide compositegate insulator for VLSI CMOS"
- JOURNAL OF THE ELECTROCHEMICAL SOCIETY. vol. 132, no. 12, December 1985,MANCHESTER, NEW HAMP pages 3001 - 3005; P. PAN et al.: "The composition andphysical properties of LPCVD Silicon Nitride deposited with different NH3/SiH2Cl2 gas ratios"
- PATENT ABSTRACTS OF JAPAN vol. 7, no. 214 (E-199)(1359) 21 September 1983,& JP-A-58 108750

## Description

The present invention relates to a method for the fabrication of ultra-thin composite dielectric, usable in dynamic random-access memory (DRAM) and other integrated circuits (IC), and particularly involving in situ deposition by the low-pressure chemical-vapor deposition (LPCVD) technique so as to be completely compatible with standard IC fabrication processes.

The dielectric presently used for the storage capacitor in large DRAM chips is composed of a triple layer of Oxide-Nitride-Oxide (ONO). The nitride is deposited on thermally grown oxide and the top layer is formed by reoxidation of the nitride to convert a thin layer of nitride to oxide. This triple layer is used, rather than a single layer of thermal oxide, because of the much lower defect density offered by ONO. It has been found that due to the low defect density of ONO very few large area capacitors of this dielectric break at high fields during voltage stress. This is especially significant for the DRAM capacitor because the total area covered by all the capacitors on one chip is relatively large and the defect density of a single oxide layer is not low enough. The ONO triple layer dielectric combines the advantages of low defect density with good interface to the silicon substrate and a high dielectric breakdown. These qualities are very important for the yield and reliability of large DRAM chips (i.e., >1Mbits).

The ONO is usually fabricated by first thermally oxidizing the surface of a silicon substrate. Next, the thin nitride layer is deposited by low-pressure-chemical-vapor-deposition (LPCVD), and the top oxide layer is then formed by thermally reoxidizing the nitride to convert a part of it to oxide. This contrasts with the different approach taught by T. Hori, and H. Iwasaki, in "Improved Transconductance Under High Normal Field in MOSFET's with Ultrathin Nitrided Oxides", IEEE Electron Device Lett., 10, 195 (1989), whereby the ONO is formed by nitridizing the first oxide in ammonia and then reoxidation, both done in a rapid-thermal-processing (RTP) tool.

As DRAM chips increase in their capacity it is required to increase the capacitance of the memory cell. To do this it is necessary to reduce the ONO thickness below its present dimension of about 14 nm. (All references to thicknesses of the composite ONO film are the so called "oxide electrical-equivalent thickness", which is the thickness of the film assuming its dielectric constant is 3.9. All thicknesses of the separate layers are their physical values either from ellipsometry or from the deposition rate and time.) To date there exists a limitation on scaling down the ONO thickness because a nitride layer thinner than about 6-7 nm cannot be reoxidized without the nitride breaking through during reoxidation which results in a thick single oxide layer. In this regard, see, for example, W.T. Chang, D.K. Shih, D.L. Kwong, Y. Zhou, and S. Lee, "Rapid Thermal Oxidation of Thin Nitride/Oxide Stacked Layers", Appl. Phys. Lett., 54, 430 (1989), which points out the reoxidation problem and describes reoxidation of, 60,90,120 Å. nitride in an RTP tool. Also, K.K. Young, W.G. Oldham, and J. Rose, in "Preparation and Characterization of 100 Å. Oxide/Nitride/Oxide Stacked Films", Electrochemical Society extended abstracts 86-2, 618 (1986), describe the breakthrough of nitride thinner than about 7 nm upon reoxidation.

Consequently, it is desirable and an object of the present invention to provide a method and means for producing an ultra-thin dielectric and one which allows the fabrication of an ONO layer as thin as about 5 nm with very low defect density in a manner completely compatible with present day DRAM fabrication technology, using the LPCVD technique.

The present invention as claimed accordingly involves a method for fabricating an ultrathin dielectric by forming a thin layer of nitride (≃ 3 nm) on a very thin LPCVD oxide, which composite may then be adapted by reoxidizing the nitride layer in such manner as to produce a triple dielectric of as little as 4.5 nm total thickness with low defect density (< 0.1 per cm²). In particular, it has been discovered that a thin nitride deposited on a very thin LPCVD oxide has much better qualities, than yet achieved in the art, provided both the oxide and nitride film are deposited in situ in the same reactor tube at very low deposition rates. The oxide deposition step requires only a few Å of oxide and may be considered as an in situ surface preparation treatment for the subsequent nitride deposition. This treatment can be applied also on a thin thermal oxide on silicon substrate.

The formation of a very thin ONO film, utilizing the ultrathin dielectric in accordance with the invention, may be achieved by thermally reoxidizing the nitride to convert part of it into an oxide, which could not previously be done on such thin nitride films.

The ONO dielectric may be formed directly on a Si substrate or following thermal oxidation or oxide deposition on the substrate.

The top-reoxidizing procedure has been found to result in films having different properties. Consequently, the resulting very thin ONO may find use in various thin dielectric applications such as the gate in FET devices or the dielectric in decoupling capacitors, etc.

Preferred embodiments of the present invention are described in the following with reference to the accompanying drawings, in which:
- Fig. 1: is a cross-sectional view illustrating one form of dielectric in accordance with the present invention;
- Fig. 2: is a view as in Fig. 1 showing an alternate form of dielectric in accordance with the invention;
- Fig. 3: shows an another form of dielectric in accordance with the invention;

Present thin dielectrics, such as the dielectric for the storage capacitor in DRAM, are composed of a triple layer of oxide-nitride-oxide (ONO). The nitride is deposited on thermally grown oxide and the top layer is formed by reoxidation of the nitride to convert a thin layer of nitride to oxide. Until now the nitride layer in such arrangements has not been able to survive reoxidation at thicknesses below 6-7 nm. In this context the invention herein involves procedures for reoxidizing a 3 nm layer of nitride in such manner as to produce a triple dielectric of as little as 4.5 nm total thickness with low defect density. In particular, it has been discovered that by depositing a thin layer of nitride on a film of CVD oxide, in situ in the same LPCVD tube, at a slow deposition rate, the resulting thin nitride will withstand reoxidation. For example, the oxide may be produced using slow oxide-deposition from SiCl₂H₂/N₂O gas at 785°C and 41.3 Pa (310 mT) to achieve a rate of 0.1 nm/min. which can be increased by raising the temperature to about 800°C. After oxide deposition the N₂O gas is turned off and NH₃ is turned on to switch to nitride deposition to a thickness of 3 nm. Such a nitride layer will then withstand reoxidation at 950°C for 20 min. in O₂ + HCl ambient giving a 4.5 nm triple dielectric capable of adaptation to a boron doped polysilicon gate, with low defect density, and an average current-density at breakdown of 0.5 A/cm². The reoxidation resistance of this nitride layer has been extended to block wet oxidation at 1000°C for anywhere between 30 and 60 min.. It has further been discovered that the thin nitride can be deposited directly on thermal oxide by giving the thermal oxide a short treatment in the LPCVD reactor of a few minutes of exposure to SiCl₂H₂/N₂O gases and then the nitride deposition is done in situ as above with comparable reoxidation qualities.

The preferred procedures for fabricating the thin ONO in accordance with the invention consist more specifically of the following steps:

### Step I.

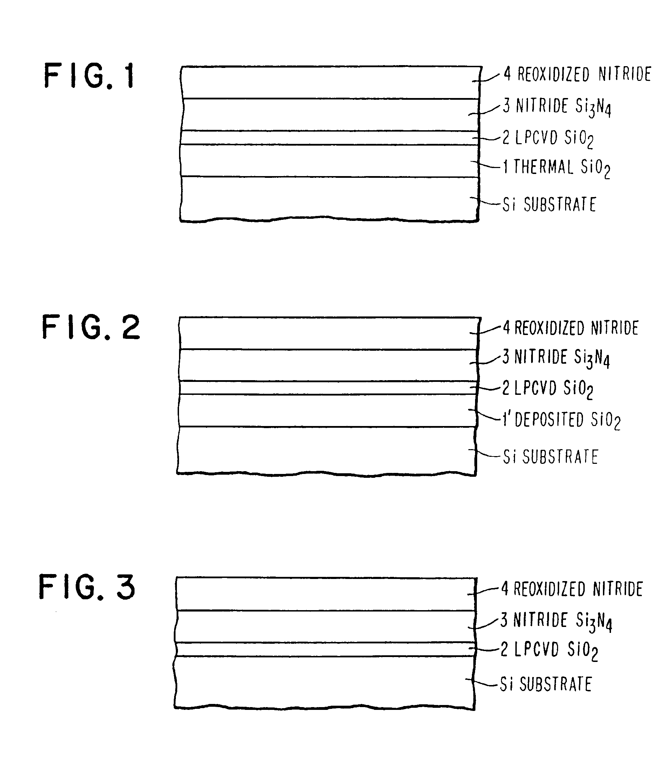

A bottom oxide layer is formed, for example, on a substrate such as a silicon substrate Si, using either of two procedures as follows.
· The silicon substrate is cleaned and then thermally oxidized by standard oxidation procedures at about 700-1000°C, for times designed to yield an oxide film (layer 1 in Figure 1) of the required thickness. In the preferred embodiment the oxide thickness is about 2.5-4 nm, thermally grown in dry oxygen at 700°C.
· Alternatively, the silicon substrate is cleaned and an oxide layer is deposited on it (layer 1′ in Fig. 2). In the preferred embodiment the oxide is deposited by LPCVD in the same tool as the subsequent nitride deposition is done. The oxide deposition is carried out by the same process as described in step 2 below giving the structure of Fig. 2.

### Step 2.

Surface preparation (layer 2) before deposition of the nitride is carried out in the same tube as the nitride deposition. More particularly, it consists of the short deposit of a low deposition-rate LPCVD oxide that should be done in situ in the same LPCVD reactor tube where the nitride deposition of step 3 is done. The gas mixture for the deposition is SiCl₂H₂/N₂O. The gas ratios are determined by the gas flow rates. The deposition temperature and pressure in the tube will determine the deposition rate. In the preferred embodiment these para-meters are a temperature of about 785°C, a pressure of about 41.3 Pa (310 mT), and approximate gas flow rates of SiCl₂H₂ at 70 sccm, and N₂O at 270 sccm (sccm is a commonly used unit meaning standard cubic centimeters per minute, wherein standard refers to a temperature of 0°C amd a pressure of 101.3 kPA (760 torr)). How-ever, these parameters may be varied within acceptable ranges, such as, temperatures between about 720-800°C, pressures between about 26.7-106.7 Pa (200-800 mT), and gas flows adjusted according to required deposition rate, e.g., 0.1 nm/min.

To ensure high quality thin nitride a minimal surface preparation time is required. The appropriate deposit time for the LPCVD oxide depends on the structure and has been found for different applications to be:
· 4 minutes when deposited on thermal oxide on the top planar silicon surface (Fig. 1);
· 1 minute on freshly cleaned bare silicon surface (Fig. 3); and
· 1 minute on CVD oxide done in another tool.

### Step 3.

Nitride deposition (layer 3) is accomplished in situ after the previous step 2 is completed. The preferred parameters are a gas mixture of SiCl₂H₂/NH₃, at a temperature of about 785°C and gas pressure of about 26.7 Pa (200 mT), and approximate gas flows of SiCl₂H₂ at 10 sccm and NH₃ at 100 sccm. Acceptable ranges include temperatures between about 720-800°C, pressures ranging between about 13.3-106.7 Pa (100-800 mT), and gas flows adjusted accordingly. In the preferred embodiment the deposition rate of nitride is 1 nm/min. and the nitride thickness can be as low as 3 nm.

### Step 4.

The final step involves the formation of a top oxide (layer 4 or 4′). This is accomplished by thermal reoxidation of the nitride. In the preferred embodiment, the nitride is reoxidized at 950°C, for 20 min. in O₂/HCl ambient. This converts part of the nitride to oxide (layer 4) without breaking through the nitride. It has been found in particular that a 4 nm nitride layer formed as in step 3 can withstand reoxidation at 1000°C, for 30 min. in wet O₂ ambient.

To test their electrical characteristics, the various ONO structures shown in Figs. 1-3 were fabricated on 125 mm silicon wafers. Capacitors were formed by standard polysilicon and aluminum electrode techniques on top of the ONO films. Electrical testing was done on capacitors having areas from 1 x 10⁻⁴ to 0.1 cm². Defect densities were measured by stressing 120 capacitors, each having an area of 0.08 cm², covering a total area of about 10 cm². Defect densities as low as 0.1 per /cm² were obtained and in several cases the defect density was found in the testing to be zero. These results were determined by the number of capacitors that broke well below the voltage determined by the dielectric strength of the film. The average dielectric strength of the films was 12-14 MV/cm. Interface trap densities determined by standard characterization techniques of the interface betwen silicon and SiO₂ were as low as for standard SiO₂.

Testing was also done for electron trapping, as nitride and deposited oxides are known to trap electrons, i.e., be very "trappy" for electrons. ONO films above about 6.5 nm thickness are quite trappy, which poses a problem for their use as FET gate dielectric.

The present invention therefore provides a composite ONO dielectric, having very low defect density and good overall electric properties, of less than 10 nm in thickness and as low as about 4.5 nm.

## Claims

1. A method for producing a low defect density ultra thin oxide/nitride/oxide (ONO) dielectric comprising the steps of:
producing a thin film of oxide (2) by deposition in an LPCVD tube;
slowly depositing a thin layer of silicon nitride (3), in situ in said LPCVD tube, from a gas mixture of SiCl₂H₂/NH₃, at a temperature in the range between 720-800°C, at a pressure in the range between 13.3-106.7 Pa (100-800 mT) and gas flows adjusted to achieve a deposition rate of 1 nm/min on said thin film of oxide, to a thickness of at least 3 nm and such that the resulting oxide-nitride structure has a thickness in the range from 4 nm up to less than 10 nm, and forming a thin layer of oxide (4) thereon to a thickness such that the thickness of the resulting composite ONO is under 10 nm, said oxide (4) being formed by thermal reoxidation of said nitride layer (3).

2. A method as in claim 1 wherein the oxide film producing step comprises depositing an oxide (2) from SiCl₂H₂/N₂O gas on a substrate in said LPCVD tube and the oxide (2) is deposited at a temperature in the range between 720-800°C, at a pressure in the range between 26.7-106.7 kPa (200-800 mT), and gas flows at a deposition rate of 0.1 nm/min.

3. A method as in claim 2 wherein the oxide (2) is deposited at a temperature of 785°C, a pressure of 41.3 Pa (310 mT), and approximate gas flow rates of SiCl₂H₂ at 70 sccm, and N₂O at 270 sccm.

4. A method as in claim 1, 2 or 3 wherein the nitride depositing step comprises depositing a layer of nitride (3) from a gas mixture of SiCl₂H₂/NH₃, at a temperature of 785°C, a pressure of 26.7 Pa (200 mT), and approximate gas flows of SiCl₂H₂ at 10 sccm, and NH₃ at 100 sccm.

5. A method as in any one of the preceding claims wherein the step of forming the thin layer of oxide (4) is carried out at 950°C, for 20 min. in O₂/HCl ambient.

6. A method as in any one of claims 1 to 3 wherein the oxide producing step further comprises cleaning and then depositing the oxide layer (2) on a silicon substrate.

7. A method as in any one of claims 1 to 3 wherein the oxide producing step further comprises cleaning and thermally oxidizing a silicon substrate, on which said thin film of oxide (2) is then to be deposited, by standard oxidation procedures at a temperature in the range between 700-1000°C, for a time yielding an oxide thickness in the range between 2.5-4 nm, in dry oxygen.

## Patentansprüche

1. Verfahren zur Herstellung eines ultradünnen Oxid/Nitrid/ Oxid(ONO)-Dielektrikums mit niedriger Defektdichte, das folgende Schritte beinhaltet:
Erzeugen eines dünnen Films aus Oxid (2) durch Deposition in einem LPCVD-Rohr;
langsames Abscheiden einer dünnen Schicht aus Siliciumnitrid (3) in-situ in dem LPCVD-Rohr aus einem SiCl₂H₂/NH₃-Gasgemisch bei einer Temperatur im Bereich zwischen 720 °C und 800 °C, bei einem Druck im Bereich zwischen 13,3 Pa und 106,7 Pa (100 mT und 800 mT) und bei Gasflüssen, die so eingestellt sind, daß eine Depositionsrate von 1 nm/min erzielt wird, auf dem dünnen Film aus Oxid mit einer Dicke von wenigstens 3 nm und derart, daß die resultierende Oxid-Nitrid-Struktur eine Dicke im Bereich von 4 nm bis hinauf zu weniger als 10 nm aufweist, und
Bilden einer dünnen Schicht aus Oxid (4) darauf mit einer solchen Dicke, daß die Dicke des resultierenden zusammengesetzten ONO unter 10 nm beträgt, wobei das Oxid (4) durch thermische Reoxidation der Nitridschicht (3) gebildet wird.

2. Verfahren nach Anspruch 1, wobei der Schritt zum Erzeugen des Oxidfilmes das Aufbringen eines Oxids (2) aus SiCl₂H₂/N₂O-Gas auf einem Substrat in dem LPCVD-Rohr beinhaltet und das Oxid (2) bei einer Temperatur im Bereich zwischen 720 °C und 800 °C, bei einem Druck im Bereich zwischen 26,7 Pa und 106,7 Pa (200 mT und 800 mT) und bei Gasflüssen für eine Depositionsrate von 0,1 nm/min aufgebracht wird.

3. Verfahren nach Anspruch 2, wobei das Oxid (2) bei einer Temperatur von 785 °C, einem Druck von 41,3 Pa (310 mT) und ungefähren Gasflußraten von 70 sccm für SiCl₂H₂ sowie 270 sccm für N₂O aufgebracht wird.

4. Verfahren nach Anspruch 1, 2 oder 3, wobei der Schritt zum Abscheiden des Nitrids das Aufbringen einer Schicht aus Nitrid (3) aus einem SiCl₂H₂/NH₃-Gasgemisch bei einer Temperatur von 785 °C, einem Druck von 26,7 Pa (200 mT) und ungefähren Gasflüssen von 10 sccm für SiCl₂H₂ sowie 100 sccm für NH₃ beinhaltet.

5. Verfahren nach einem der vorhergehenden Ansprüche, wobei der Schritt zur Bildung der dünnen Schicht aus Oxid (4) bei 950 °C während 20 min in einer O₂/HCl-Umgebung ausgeführt wird.

6. Verfahren nach einem der Ansprüche 1 bis 3, wobei der Schritt zum Erzeugen des Oxids des weiteren ein Reinigen und ein darauffolgendes Aufbringen der Oxidschicht (2) auf einem Siliciumsubstrat beinhaltet.

7. Verfahren nach einem der Ansprüche 1 bis 3, wobei der Schritt zum Erzeugen des Oxids des weiteren ein Reinigen und ein thermisches Oxidieren eines Siliciumsubstrates, auf dem der dünne Film aus Oxid (2) dann aufzubringen ist, durch standardmäßige Oxidationsverfahren bei einer Temperatur im Bereich zwischen 700 °C und 1000 °C während einer Zeitdauer, bei der sich eine Oxiddicke im Bereich zwischen 2,5 nm und 4 nm ergibt, in trockenem Sauerstoff beinhaltet.

## Revendications

1. Procédé de fabrication d'un mince diélectrique d'oxyde/nitrure ultra mince à faible densité de défauts, comprenant les étapes de:
former un mince film d'oxyde (2) par dépôt dans un tube LPCVD;
déposer lentement une mince couche de nitrure de silicium (3) sur place dans ledit tube LPCVD à partir d'un mélange gazeux de SiCl₂H₂/NH₃, à une température dans la gamme se situant entre 720-800°C, à une pression dans la gamme se situant entre 13,3-106,7 Pa (100-800 mT) sur ledit mince film d'oxyde, sur une épaisseur d'au moins 3 nm et de façon que la structure d'oxyde-nitrure ait une épaisseur dans la gamme allant de 4 nm jusqu'à moins de 10 nm, et former une mince couche d'oxyde (4) dessus sur une épaisseur de sorte que l'épaisseur de la couche composite ONO obtenue finalement soit inférieure à 10 nm, ledit oxyde (4) étant formé par réoxydation thermique de ladite couche de nitrure (3).

2. Procédé selon la revendication 1, dan lequel l'étape de formation du film d'oxyde comprend le dépôt d'un oxyde (2) à partir de gaz de SiCl₂H₂/N₂O sur un substrat dans ledit tube LPCVD, et l'oxyde (2) est déposé à une température dans la gamme située entre 720-800°C, à une pression dans la gamme située entre 26,7-106,7 kPa (200-800 mT) le débit de gaz étant déposé à une cadence de 0,1 nm/min.

3. Procédé selon la revendication 2, dans lequel l'oxyde (2) est déposé à une température de 785°C, à une pression de 41,3 Pa (310 mT), et des débits de gaz de SiCl₂H₂ approximativement à 70 cm3/min et de N₂O à 270 cm3/min.

4. Procédé selon les revendications 1, 2 ou 3, dans lequel l'étape de dépôt de nitrure comprend le dépôt d'une couche de nitrure (3) à partir d'un mélange gazeux de SiCl₂H₂/NH₃, à une température de 785°C, une pression de 26,7 Pa (200 mT), et des débits de gaz de SiCl₂H₂ approximativement à 10 cm3/min, et de NH₃ à 100 cm3/min.

5. Procédé selon l'une quelconque des revendications précédentes, dans lequel l'étape de formation de la mince couche d'oxyde (4) est faite à 950°C, pendant 20 min. dans une ambiance de O₂/HCl.

6. Procédé selon l'une quelconque des revendications 1 à 3, dans lequel l'étape de formation d'oxyde comprend en outre le nettoyage et ensuite le dépôt de la couche d'oxyde (2) sur un substrat de silicium.

7. Procédé selon l'une quelconque des revendications 1 à 3, dans lequel l'étape de formation d'oxyde comprend en outre le nettoyage et l'oxydation thermique d'un substrat de silicium sur lequel ledit mince film d'oxyde (2) doit alors être déposé, par des procédures d'oxydation standard à une température dans la gamme située entre 700-1000°C, pendant un temps fournissant une épaisseur d'oxyde dans la gamme située entre 2,5-4 nm, dans de l'oxyde sec.
